# EUROPÄISCHE PATENTANMELDUNG

(11) **EP 1 489 659 A1**
(43) Veröffentlichungstag der Anmeldung: **22.12.2004**
(21) Anmeldenummer: 03405437.9
(22) Anmeldetag: 18.06.2003
(51) Int. Cl.: H01L 23/485

(54) **Kontaktmetallisierung für Halbleiterbauelemente**

(71) Anmelder: ABB Technology AG, 8050 Zürich (CH)
(72) Erfinder: Tiemann, Uwe, 79793 Wutöschingen (DE); Herr, Egon, 8037 Zürich (CH); Assal, Jérôme, 8004 Zürich (CH)
(74) Vertreter: ABB Patent Attorneys

(57) **Zusammenfassung**

Bei einem Halbleiterbauelement mit einem Halbleitersubstrat (1) mit mindestens einer ersten Kontaktfläche; einer erste Metallisierungslage (2), welche auf der Kontaktfläche aufgebracht ist,; einer zweiten Metallisierungslage (3), welche mit der ersten Metallisierungslage (2) in elektrisch leitendem Kontakt steht wird eine verbesserte Zuverlässigkeit erfindungsgemäss dadurch erreicht, dass auf einem ersten Teilbereich einer vom Halbleitersubstrat (1) abgewandten ersten Oberfläche der ersten Metallisierungslage (2) eine Passivierungsschicht (4) vorgesehen ist und dass die zweite Metallisierungslage (3) einen zweiten Teilbereich der ersten Oberfläche und die Passivierungsschicht (4) zumindest teilweise überdeckt.

## Beschreibung

### Technisches Gebiet

Die vorliegende Erfindung bezieht sich auf das Gebiet der Halbleitertechnik. Sie betrifft ein Halbleiterbauelement, insbesondere ein druckkontaktierbares Leistungshalbleiterbauelement, nach dem Oberbegriff von Patentanspruch 1.

### Stand der Technik

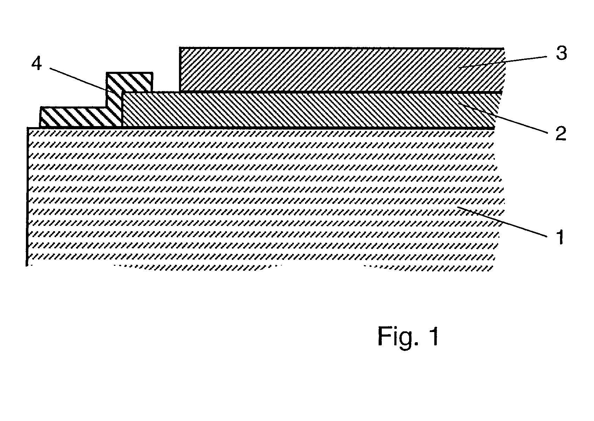

Eine Kontaktmetallisierung auf einer Kontaktfläche von Leistungshalbleiterbauelementen ist häufig aus zwei übereinanderliegenden Metallisierungslagen aufgebaut. Eine erste Metallisierungslage aus Aluminium, welche mit einem Halbleitermaterial des Leistungshalbleiterbauelements, im Allgemeinen Silizium, gesättigt ist, ist direkt auf der Oberfläche des Leistungshalbleiterbauelements aufgebracht. Eine zweite Metallisierungslage aus im wesentlichen reinen Aluminium ist auf der ersten Metallisierungslage aufgebracht. Insbesondere wird eine derartige Kontaktmetallisierung häufig bei Leistungsdioden auf einer Anodenseite und bei Bipolartransistoren mit isolierter Steuerelektrode (englisch: insulated gate bipolar transistor, IGBT) auf einer Kathodenseite eingesetzt. Bei bestimmten IGBT-Ausführungsformen, insbesondere bei IGBTs, bei welchen eine Vielzahl elektrisch parallel geschalteter IGBT-Zellen in einem gemeinsamen Halbleitersubstrat ausgebildet ist, wird dabei eine elektrisch isolierte Gateelektrode, welche beispielsweise eine Anzahl von Gatefingern aufweist, von der Kontaktmetallisierung mindestens teilweise überdeckt. Die elektrische Isolation wird dabei im Allgemeinen von einer Oxidschicht bewerkstelligt, mit welcher die Gateelektrode überzogen ist. Ein nicht von der Kontaktmetallisierung bedeckter erster Randbereich der Leistungshalbleiterbauelemente ist dabei von einer Passivierungsschicht bedeckt. Die Passivierungsschicht ist dabei häufig so ausgeführt, dass sie auch einen nicht von der zweiten Metallisierungslage bedeckten zweiten Randbereich der ersten Metallisierungslage zumindest teilweise bedeckt. Dies ist in Fig. 1 dargestellt, welche einen Schnitt durch ein Leistungshalbleiterbauelement mit erster und zweiter Metallisierungslage und Passivierungsschicht nach dem Stand der Technik zeigt.

Derartige Leistungshalbleiterbauelemente werden häufig als Halbleiterchip in druckkontaktierbaren Leistungshalbleitermodulen eingesetzt, wie beispielsweise in der EP 989 611 A2 beschrieben. Die Kontaktmetallisierung entspricht dabei einer der beiden Hauptelektroden. Ein wichtiger Aspekt bei derartigen Leistungshalbleitermodulen ist eine Ausbildung eines stabilen Kurzschlusses (englisch "short circuit failure mode", SCFM) im Falle eines Defekts des Leistungshalbleiterbauelements, wie ebenfalls in der EP 989 611 A2 beschrieben wird. Die Ausbildung des stabilen Kurzschlusses kann dadurch unterstützt werden, dass ein geeigneter Eutektikumspartner in direktem Kontakt mit einer der beiden Hauptelektroden vorgesehen wird.

Es zeigt sich nun, dass bei einer Belastung durch thermische Zyklen, insbesondere in Verbindung mit Feuchtigkeit, eine Zuverlässigkeit von Leistungshalbleiterbauelementen mit der eingangs beschriebenen Kontaktmetallisierung verbesserungsbedürftig ist.

### Darstellung der Erfindung

Es ist somit Aufgabe der Erfindung, ein Halbleiterbauelement, insbesondere ein für den Einsatz in druckkontaktierbaren Leistungshalbleitermodulen geeignetes Leistungshalbleiterbauelement, anzugeben, welches eine verbesserte Zuverlässigkeit aufweist.

Diese und weitere Aufgaben werden durch ein Halbleiterbauelement der eingangs genannten Art mit den Merkmalen des unabhängigen Patentanspruchs gelöst. Weitere vorteilhafte Ausgestaltungen der Erfindung sind in den abhängigen Ansprüchen angegeben.

Bei einem erfindungsgemässen Halbleiterbauelement ist eine Passivierungsschicht auf einem ersten Teilbereich einer vom Halbleitersubstrat abgewandten Oberfläche einer ersten Metallisierungslage vorgesehen, wobei eine zweite Metallisierungslage die Passivierungsschicht und einen zweiten Teilbereich der Oberfläche zumindest teilweise überdeckt.

Das erfindungsgemässe Halbleiterbauelement ist gegenüber herkömmlichen Leistungshalbleiterbauelementen wesentlich zuverlässiger, wie sich in beschleunigten Belastungstests, d.h. unter erhöhter Temperatur, Feuchtigkeit und Strom, herausstellt.

In einer bevorzugten Weiterbildung der Erfindung wird als Material für die Passivierungsschicht Siliziumnitrid gewählt. Siliziumnitrid unterstützt dabei im Falle eines Defekts des Leistungshalbleiterbauelements eine Eutektikumsbildung zwischen einem Halbleitermaterial und Metallen der ersten und/oder zweite Metallisierungslage, und somit eine Ausbildung eines stabilen Kurzschlusses.

In einer bevorzugten Weiterbildung der Erfindung umfasst die zweite Metallisierungslage eine Titanschicht, welche sich in direktem Materialkontakt mit der ersten Metallisierungslage und der Passivierungsschicht befindet, eine Nickelschicht, welche auf der Titanschicht aufgebracht ist, und eine Silberschicht, welche auf der Nickelschicht aufgebracht ist. Eine solche zweite Metallisierungslage weist besonders günstige Eigenschaften im Hinblick auf Reibung auf, welche sich bei einem Einsatz des Leistungshalbleiterbauelements in druckkontaktierbaren Leistungshalbleitermodulen aufgrund unterschiedlicher thermischer Ausdehnungskoeffizienten von Halbleitermaterial und elektrischen Kontaktelementen, wie beispielsweise Kontaktstempel, - scheiben oder -folien oder auch Lotschichten, im Leistungshalbleitermodul ergibt. Die Silberschicht hat zudem den Vorteil, dass Silber nicht oxidierbar ist und sich folglich keine harten Oxidpartikel ausbilden können, die eine Qualität eines elektrischen Druckkontakts zwischen zweiter Metallisierungslage und den elektrischen Kontaktelementen nachteilig beeinflussen könnten.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit der Zeichnung offensichtlich.

### Kurze Beschreibung der Zeichnung

Fig. 1 zeigt, einen Schnitt durch ein Halbleiterbauelement mit erster und zweiter Metallisierungslage und Passivierungsschicht nach dem Stand der Technik.

Fig. 2a zeigt einen Schnitt durch ein erfindungsgemässes Halbleiterbauelement.

Fig. 2b zeigt einen Schnitt entlang der Linie A-B aus Fig. 2a.

Fig. 3a zeigt einen Schnitt durch eine bevorzugte Ausgestaltung eines erfindungsgemässen Halbleiterbauelements.

Fig. 3b zeigt einen Schnitt entlang der Linie A-B aus Fig. 3a.

Fig. 4a zeigt einen Schnitt durch eine weitere bevorzugte Ausgestaltung eines erfindungsgemässen Halbleiterbauelements.

Fig. 4b zeigt einen Schnitt entlang der Linie A-B aus Fig. 4a.

Die in der Zeichnung verwendeten Bezugszeichen und deren Bedeutung sind in der Bezugszeichenliste zusammengefasst. Grundsätzlich bezeichnen gleiche Bezugszeichen gleiche Teile.

### Wege zur Ausführung der Erfindung

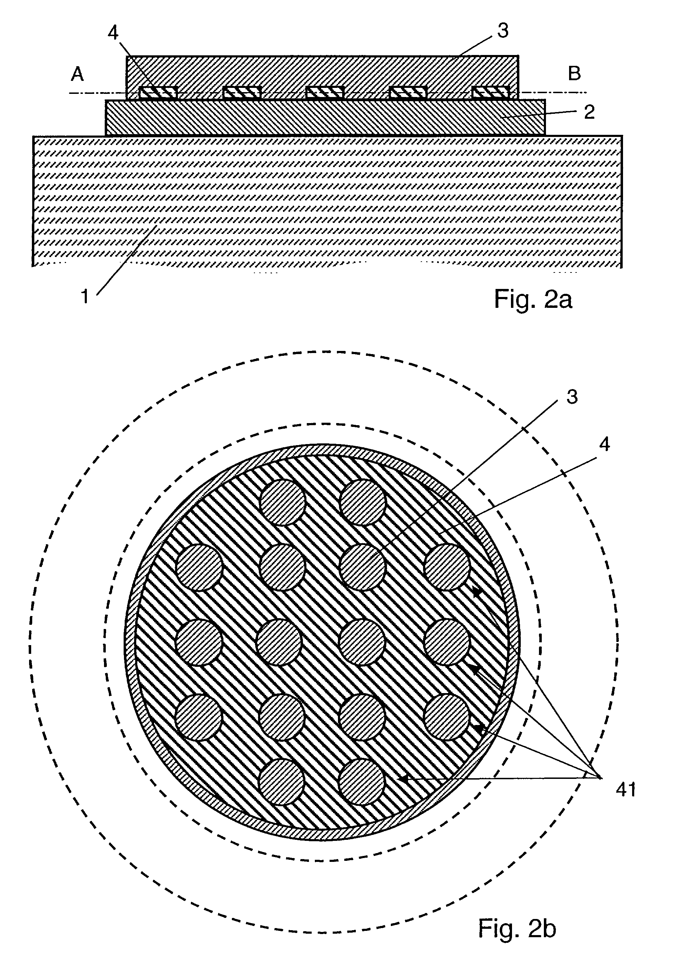

Fig. 2a zeigt einen Schnitt durch ein erfindungsgemässes Halbleiterbauelement. Eine erste Aluminiumschicht 2 ist als erste Metallisierungslage auf einer Kontaktfläche des Halbleitersubstrats 1 aufgebracht. Ein Siliziumanteil in der Aluminiumschicht 2 beträgt dabei vorzugsweise zwischen 0.5% und 2%, eine Dicke der ersten Aluminiumschicht 2 liegt vorzugsweise zwischen 1.0 µm und 10.0 µm. Auf einem ersten Teilbereich einer vom Halbleitersubstrat 1 abgewandten ersten Oberfläche der ersten Aluminiumschicht 2 ist eine Siliziumnitridschicht 4 als Passivierungsschicht aufgebracht. Eine Dicke der Siliziumnitridschicht 4 beträgt vorzugsweise zwischen 0.5µm und 2.0µm. Der erste Teilbereich bildet ein zusammenhängendes Gebiet, wie aus Fig. 2b zu sehen ist, die einen Schnitt entlang der Linie A-B aus Fig. 2a darstellt. Dies ergibt einen mechanischen Schutz für das Halbleitersubstrat 1, insbesondere bei einer Verwendung des erfindungsgemässen Halbleiterbauelements in druckkontaktierbaren Leistungshalbleitermodulen. Eine Anzahl Kontaktöffnungen 41 in der Siliziumnitridschicht 4 definiert einen zweiten Teilbereich auf der vom Halbleitersubstrat 1 abgewandten ersten Oberfläche der ersten Aluminiumschicht 2. Eine zweite Aluminiumschicht 3 ist so auf der Siliziumnitridschicht 4 aufgebracht, dass sie sowohl diese als auch den zweiten Teilbereich überdeckt. Eine Dicke der zweiten Aluminiumschicht 3 liegt vorzugsweise zwischen 1.0µm und 12.0 µm. Im einem Bereich der Kontaktöffnungen 41 stehen die erste Aluminiumschicht 2 und die zweite Aluminiumschicht 3 in einem direktem Materialkontakt zueinander, so dass eine elektrisch leitende Verbindung zwischen der ersten Aluminiumschicht 2 und der zweiten Aluminiumschicht 3 resultiert.

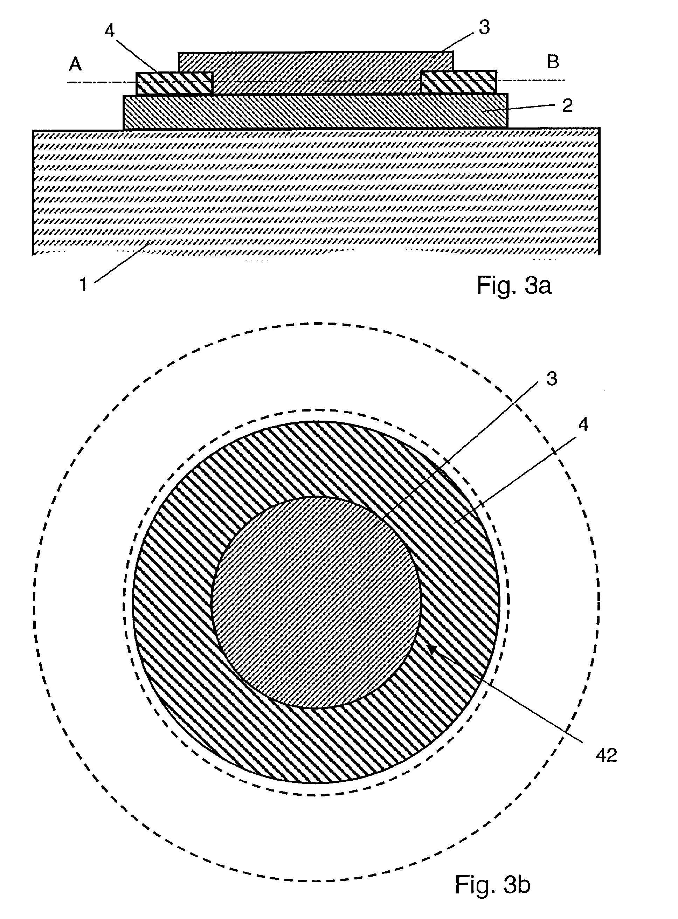

Fig. 3a zeigt einen Schnitt durch eine bevorzugte Ausgestaltung eines erfindungsgemässen Halbleiterbauelements. Der erste Teilbereich der vom Halbleitersubstrat 1 abgewandten ersten Oberfläche der ersten Aluminiumschicht 2, auf welchem die Siliziumnitridschicht 4 aufgebracht ist, verläuft dabei parallel zu einem Rand der ersten Aluminiumschicht 2, wie aus Fig. 3b zu ersehen ist, die einen Schnitt entlang der Linie A-B aus Fig. 3a darstellt. Die Siliziumnitridschicht 4 bildet somit einen Kreisring, der konzentrisch zur ersten Aluminiumschicht 2 angeordnet ist, und eine einzelne kreisförmige Kontaktöffnung 42 aufweist.

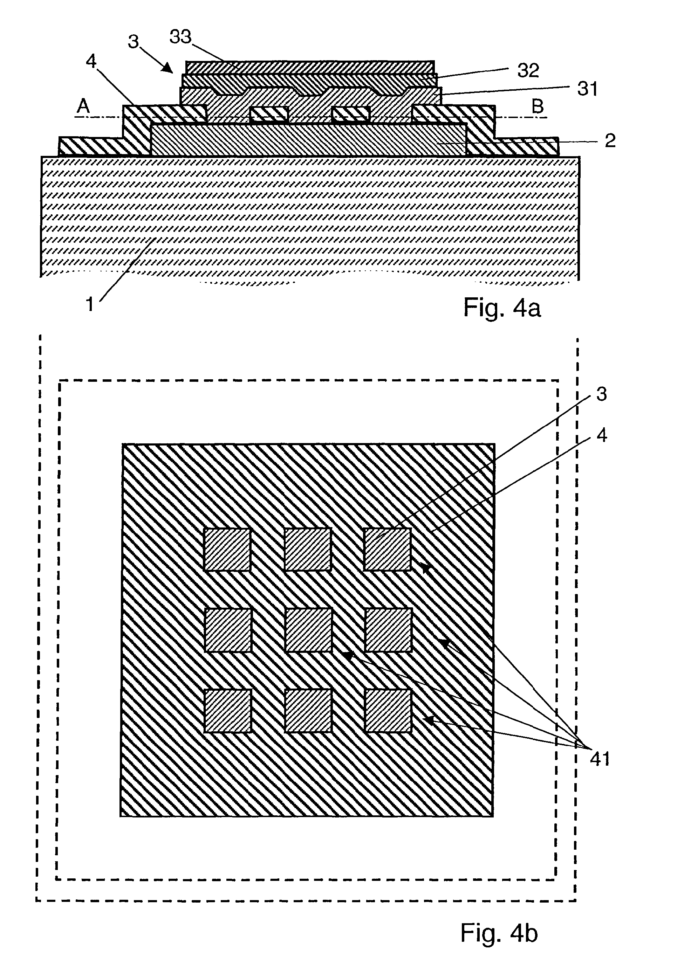

Fig. 4a zeigt einen Schnitt durch eine weitere bevorzugte Ausgestaltung eines erfindungsgemässen Halbleiterbauelements. Die zweite Metallisierungslage 3 ist dabei aus einer Titanschicht 31, welche sich in direktem Materialkontakt mit der ersten Aluminiumschicht 2 und der Siliziumnitridschicht 4 befindet, einer Nickelschicht 32, welche auf der Titanschicht 31 aufgebracht ist, und einer Silberschicht 33, welche auf der Nickelschicht 32 aufgebracht ist, aufgebaut. Dabei weist die Titanschicht 31 vorzugsweise eine Dicke zwischen 0.1µm und 2.0 µm, die Nickelschicht 32 vorzugsweise eine Dicke zwischen 0.1µm und 2.0 µm und die Silberschicht 33 vorzugsweise eine Dicke zwischen 0.2 µm und 10.0 µm auf. Die Titanschicht 31 gewährleistet dabei eine gute Haftung der zweiten Metallisierungslage 3 auf der Siliziumnitridschicht 4 und der ersten Aluminiumschicht 2, und dient darüber hinaus als eine erste Diffusionsbarriere für Aluminium einerseits und Feuchtigkeit andererseits. Die Nickelschicht 32 wiederum dient als eine zweite Diffusionsbarriere für Sauerstoff und Silber, und erhöht zudem eine Haftung der Silberschicht 33. Die Silberschicht 33 schliesslich ist aufgrund einer hohen Leitfähigkeit und Oxidationsbeständigkeit von Silber vorteilhaft für die Verwendung des erfindungsgemässen Halbleiterbauelements in druckkontaktierbaren Leistungshalbleitermodulen, insbesondere druckkontaktierbaren Leistungshalbleitermodulen mit nicht luftdicht abgeschlossenem Gehäuse. Die Siliziumnitridschicht 4 ist ferner über den Rand der ersten Aluminiumschicht 2 auf das Halbleitersubstrat 1 heruntergezogen und überdeckt einen nicht metallisierten Randbereich, im Allgemeinen einen Randabschluss (engl. "junction termination"), des Halbleitersubstrats 1. Die erste Aluminiumschicht 2 ist somit durch das Halbleitersubstrat 1, die Siliziumnitridschicht 4 und die zweite Metallisierungslage 3 hermetisch gegen eine Umgebungsatmosphäre und somit auch gegen Feuchtigkeit abgeschirmt. Die Silberschicht 33 führt zudem zu einer nochmals verbesserten Oxidations- und Korrosionsbeständigkeit des erfindungsgemässen Halbleiterbauelements.

### Bezugszeichenliste

- 1: Halbleitersubstrat
- 2: Erste Metallisierungslage, erste Aluminiumschicht
- 3: Zweite Metallisierungslage, zweite Aluminiumschicht
- 4: Passivierungsschicht, Siliziumnitridschicht
- 31: Titanschicht
- 32: Nickelschicht
- 33: Silberschicht
- 41: Kontaktöffnungen
- 42: Kontaktöffnung

## Patentansprüche

1. Halbleiterbauelement, umfassend
- ein Halbleitersubstrat (1) mit mindestens einer ersten Kontaktfläche,
- eine erste Metallisierungslage (2), welche auf der Kontaktfläche aufgebracht ist,
- eine zweite Metallisierungslage (3), welche mit der ersten Metallisierungslage (2) in elektrisch leitendem Kontakt steht,
**dadurch gekennzeichnet, dass**
- auf einem ersten Teilbereich einer vom Halbleitersubstrat (1) abgewandten ersten Oberfläche der ersten Metallisierungslage (2) eine Passivierungsschicht (4) vorgesehen ist, wobei die zweite Metallisierungslage (3) einen zweiten Teilbereich der ersten Oberfläche und die Passivierungsschicht (4) zumindest teilweise überdeckt.

2. Halbleiterbauelement nach Anspruch 1, **dadurch gekennzeichnet, dass** die Passivierungsschicht (4) im wesentlichen aus Siliziumnitrid besteht.

3. Halbleiterbauelement nach einem der vorangehenden Ansprüche, **dadurch gekennzeichnet, dass** der erste Teilbereich im wesentlichen parallel zu einem Rand der ersten Metallisierungslage (2) verläuft.

4. Halbleiterbauelement nach einem der vorangehenden Ansprüche, **dadurch gekennzeichnet, dass** die zweite Metallisierungslage (3) eine Titanschicht (31), welche sich in Materialkontakt mit der ersten Metallisierungslage (2) und der Passivierungsschicht (4) befindet, eine Nickelschicht (32), welche auf der Titanschicht (31) aufgebracht ist, und eine Silberschicht (33), welche auf der Nickelschicht (32) aufgebracht ist, umfasst.

5. Halbleiterbauelement nach einem der vorangehenden Ansprüche, **dadurch gekennzeichnet, dass** das Halbleitersubstrat (1), die Passivierungsschicht (4) und die zweite Metallisierungslage (3) die erste Metallisierungslage (2) hermetisch gegen eine Umgebungsatmosphäre abschliessen.
